Europäisches Patentamt

European Patent Office

Office européen des brevets

(11) Publication number: **0 081 283**
**B1**

(12) **EUROPEAN PATENT SPECIFICATION**

(45) Date of publication of patent specification: **19.08.87**

(51) Int. Cl.⁴: **G 03 F 7/20**

(21) Application number: **82305117.2**

(22) Date of filing: **28.09.82**

(54) Electron beam exposure method and apparatus.

(30) Priority: **30.09.81 JP 155410/81**
**30.09.81 JP 155411/81**

(43) Date of publication of application:
**15.06.83 Bulletin 83/24**

(45) Publication of the grant of the patent:
**19.08.87 Bulletin 87/34**

(84) Designated Contracting States:
**DE FR GB**

(56) References cited:
**DE-A-2 600 137**
**DE-A-3 130 422**
**GB-A-2 081 003**

(73) Proprietor: **FUJITSU LIMITED**
**1015, Kamikodanaka Nakahara-ku**
**Kawasaki-shi Kanagawa 211 (JP)**

(72) Inventor: **Arii, Katsuyuki**
**Taunhausu-Ochiai 12-3 3, Ochiai 5-chome**
**Tama-shi Tokyo 192-02 (JP)**
Inventor: **Katoh, Shinya**
**Kopo-Suzuki 101 52 Suge Tama-ku**
**Kawasaki-shi Kanagawa 214 (JP)**
Inventor: **Chonan, Tsunehiro**
**1-47-2 Hairando Yokosuka-shi**
**Kanagawa 239 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

**0 081 283**

## Description

The present invention relates to an electron beam exposure method using two electron beam sources and to an electron beam exposure apparatus including two electron beam sources. This method and apparatus can be used to manufacture semiconductor devices.

In the electron beam exposure process applied to a mask or a semiconductor wafer, the beam acceleration voltage $V_{AC}$ is a very important factor. The beam image spread on the resist surface and the resist sensitivity of the electron beam change in accordance with the beam acceleration voltage $V_{AC}$. When the beam acceleration voltage $V_{AC}$ is high, it is easy to focus the electron beam to a small beam diameter, but the resist sensitivity is low.

One attempt to overcome these conflicting requirements is disclosed in DE—A—2600137. In this example as an electron beam is scanned over a resist surface the acceleration voltage applied to it switches between a high and a low level. In this way the edges of the pattern formed in the resist are exposed with a high acceleration voltage and the central part of the pattern between the edges are exposed with a low acceleration voltage.

In addition, to form a required pattern on the resist film on the wafer by projecting an electron beam, it is necessary to detect with a high precision the position on which the electron beam is actually projected. Even higher precision in detecting the above-mentioned position has become necessary as the integration scale of IC's has become greater and the circuit patterns of IC's have become finer. The above-mentioned position detection can be effected by using the fact that when an electron beam is projected on the surface of the resist, electrons are reflected from the surface. An unevenness of the resist surface can be detected from the change in the amount of the reflected electrons, thereby enabling position information to be obtained. For example, if the detected unevenness of the wafer surface is due to a position mark or alignment mark formed previously on the wafer surface for position detection, the wafer position can be determined from the detection of the mark. If the detected unevenness of the wafer surface is due to the electrode wiring line in the first layer formed on the wafer surface, since the wiring pattern in the first layer is previously determined, the wafer position can be determined from the wiring pattern information and the detection of the electrode wiring line.

However, if the diameter of the electron beam is wide, it is impossible to detect the unevenness with high precision. On the other hand, if the diameter of the electron beam is narrow, the amount of the reflected electrons varies sharply. Thus, from the point of view of position detection, the diameter of the electron beam should be narrow. However, a narrow beam diameter results in the problem of long exposure time, as described above. Thus, it is impossible to satisfy these two conflicting requirements and, in general, a compromise has been reached between the two.

According to one aspect of this invention an electron beam exposure method comprises the steps of

generating a high acceleration voltage electron beam from a high acceleration voltage electron beam source and a low acceleration voltage electron beam from a low acceleration voltage electron beam source, both the electron beams being controlled independently in an electron beam exposure apparatus;

forming fine patterns on a resist layer formed on a substrate by scanning the high acceleration voltage electron beam from the source in one predetermined area of a surface of the resist layer; and,

forming coarse patterns on the resist layer by scanning the low acceleration voltage electron beam from the source in another, different, predetermined area of a surface of the resist layer.

According to another aspect of this invention an electron beam exposure method comprises the steps of

generating a high acceleration voltage electron beam from a high acceleration voltage electron beam source and a low acceleration voltage electron beam from a low acceleration voltage electron beam source, both electron beams being controlled independently in an electron beam exposure apparatus, the high acceleration voltage electron beam being focussed to a narrow beam diameter and having an intensity weak enough not to cause substantial exposure of the resist layer;

scanning the high acceleration voltage electron beam from the source over the surface of a resist layer formed on a substrate;

obtaining information on the position of the substrate by detecting electrons reflected from the high acceleration voltage electron beam; and,

forming predetermined patterns on the resist layer by projecting the low acceleration voltage electron beam from the source onto the resist layer, the projection position of the low acceleration voltage electron beam being determined from the obtained information on the position of the substrate.

The present invention also embraces apparatus including two independently controllable electron beam sources capable of use in accordance with the above methods.

Particular examples of a method and apparatus in accordance with this invention will now be described with reference to the accompanying drawings; in which:—

Figure 1 illustrates the exposure effects of the high acceleration voltage electron beam and the low acceleration voltage electron beam;

Figures 2(a) and 2(b), and 2(c) illustrate the position detection effect of using reflected electrons from the electron beam;

Figure 3 is a schematic representation of a first example of electron beam exposure apparatus; and,

2

Figure 4 is a schematic representation of a second example of electron beam exposure apparatus.

In the electron beam exposure process applied to a mask or a semiconductor wafer, the beam acceleration voltage $V_{AC}$ is a very important factor. The beam image spread on the resist surface and the resist sensitivity of the electron beam change in accordance with the beam acceleration voltage $V_{AC}$. When the beam acceleration voltage $V_{AC}$ is high, it becomes easy to focus the electron beam to a small beam diameter, but the resist sensitivity becomes low. Conversely, when the beam acceleration voltage $V_{AC}$ is low, it becomes difficult to focus the electron beam to a small beam diameter, but the resist sensitivity becomes high.

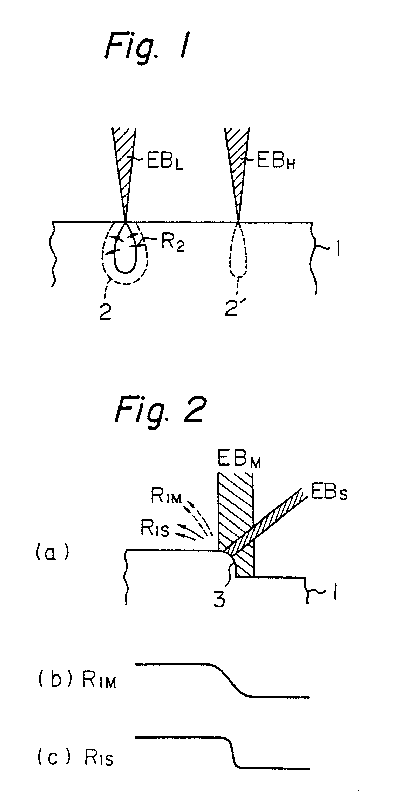

The above is illustrated in Figure 1. In Figure 1, $EB_L$ indicates a low acceleration voltage ($V_{AC}$=5 to 20 kV) electron beam, and $EB_H$ indicates a high acceleration voltage ($V_{AC}$=20 to 50 kV) electron beam. When the resist 1 is exposed to the electron beams $EB_L$ and $EB_H$, a reaction is caused in the inner region 2 and 2' of the resist 1. The high acceleration voltage electron beam tends to penetrate straight into the resist 1 and passes through the resist 1 without being scattered. Thus, the reacting region 2' exposed by the beam $EB_H$ is narrow (that is, the beam image spread is small). Accordingly, the beam $EB_H$ can be advantageously used to draw fine patterns. However, since the resist sensitivity of the high acceleration voltage electron beam $EB_H$ is low, the exposure time necessary to form a desired pattern by the beam $EB_H$ is long. Accordingly, it takes longer than necessary to draw a coarse pattern.

The low acceleration voltage electron beam $EB_L$ tends to penetrate the resist 1 while colliding with the inner atoms, emitting secondary electrons, and scattering. The secondary electrons $R_2$ produced by the electron beam react with the resist 1 to form the reacting region 2. The image projected on the resist 1 spreads like a water droplet, making the electron beam $EB_L$ unsuitable for drawing fine patterns. However, the low acceleration voltage electron beam is advantageous for forming coarse patterns because its exposure time is short.

However, if the diameter of the electron beam is wide, as shown as $EB_M$ in Figure 2(a), it is impossible to detect the boundary 3 of the step portion of the resist 1 to a high precision. For example, if the electron beam $EB_M$ is scanned from the left to the right in the drawing, the amount of the reflected electrons $R_{1M}$ varies as shown in Figure 2(b) and, as seen from the curve of Figure 2(b), the variation of the amount of the reflected electrons corresponding to the boundary of the step portion 3 does not appear so clearly. On the other hand, if the diameter of the electron beam is narrow, as shown as $EB_S$ in Figure 1(a), the amount of the reflected electrons $R_{1S}$ varies sharply correspondingly to the boundary of step 3 as shown in Figure 2(c). Thus, from the point of view of position detection, the diameter of the electron beam should be narrow. However, a narrow beam diameter results in the problem of long exposure time, as described above.

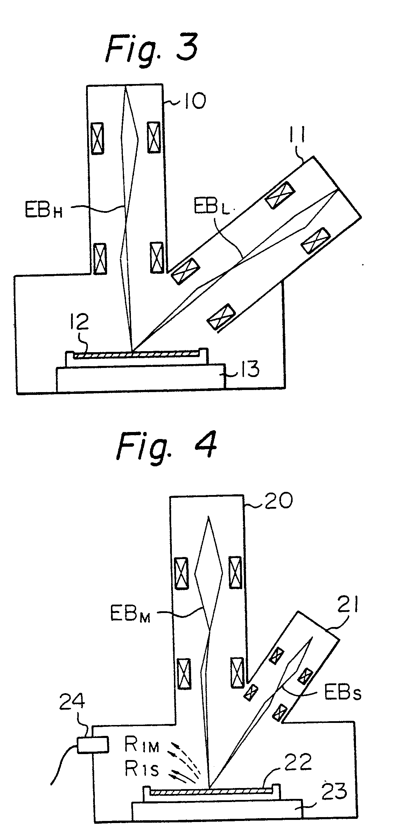

One embodiment of the present invention is illustrated in Figure 3. In Figure 3, 10 indicates a high acceleration voltage (for example, $V_{AC}$=30 kV) electron beam source, 11 indicates a low acceleration voltage (for example, $V_{AC}$=10 kV) electron beam source, 12 indicates a semiconductor wafer, and 13 indicates an XY moving table. The electron beams $EB_H$ and $EB_L$ respectively emitted from the above-mentioned electron beam sources 10 and 11 and controlled independently are projected on the wafer 12. The formation of fine patterns on the surface of the wafer 12 is carried out by the high acceleration voltage electron beam $EB_H$, while the formation of rough patterns on the surface of the wafer 12 is carried out by the low acceleration voltage electron beam $EB_L$. In order to form fine patterns, it is necessary to focus the electron beam to a small beam diameter. The high acceleration voltage electron beam $EB_H$ is advantageous for forming fine paterns, as described above. On the other hand, the low acceleration voltage electron beam $EB_L$ is advantageous for forming rough patterns.

The following table shows the relation of the acceleration voltage of the electron beam to its beam diameter and to its resist sensitivity.

TABLE

| Acceleration voltage (kV) | Beam diameter (µm) | Resist sensitivity (c/cm$^2$) |
|---|---|---|
| 5 | 1.0 | $3 \times 10^{-7}$ |
| 10 | 0.3 | $1 \times 10^{-6}$ |
| 20 | 0.22 | $3 \times 10^{-6}$ |
| 40 | 0.20 | $7 \times 10^{-6}$ |

In the electron beam exposure process, a small beam diameter is desirable for the formation of fine patterns, and a high resist sensitivity means a short exposure time per unit area.

As seen from the above table, according to the above-mentioned electron beam exposure method in which fine patterns are formed by the high acceleration voltage electron beam and rough patterns are formed by the low acceleration voltage electron beam, the exposure time necessary for a piece of wafer on which not only rough patterns but also fine patterns are formed can be shortened without decreasing the precision of the pattern formation.

The electron beam exposure of the wafer is generally carried out by using a scanning method. In this scanning method, for example, a field of 4 mm square is considered one unit area for one exposure process. The electron beam is scanned in this field and turned on and off during scanning so as to form desired patterns. In the case of the electron beam exposure process of Figure 3, the two electron beams $EB_H$ and $EB_L$ are simultaneously scanned in the above-mentioned field and independently turned on and off so that the electron beam $EB_H$ draws fine patterns and the electron beam $EB_L$ draws rough patterns. When the exposure process of one field is finished, the driving motor of the XY moving table 13 is activated to move the wafer 12 by one field pitch. Then, the above-mentioned process is repeated.

As described above, according to the embodiment of Figure 3 of the present invention, fine and rough patterns can be formed on the wafer surface with high precision in a short exposure time by using a high acceleration voltage electron beam with a small beam diameter and a low acceleration voltage electron beam with a large beam diameter.

Another embodiment of the present invention is illustrated in Figure 4. In Figure 4, 20 indicates a main electron beam source, 21 indicate a sub-electron beam source, 22 indicates a wafer, 23 indicates an XY moving table, and 24 indicates a detector of the reflected electrons. The main electron beam source 20 emits a main electron beam $EB_M$ used for the exposure of the wafer. The acceleration voltage of the electron beam $EB_M$ is low, for example $V_{AC}=10$ kV. The sub-electron beam source 21 emits a sub-electron beam $EB_S$ used for detecting the wafer position. The acceleration voltage of the electron beam $EB_S$ is high, for example $V_{AC}=40$ kV. The electron beams $EB_M$ and $EB_S$ are projected on the wafer 22, and the amount of the reflected electrons is detected by the detector 24, comprised of, for example a scintillator.

Since the acceleration voltage of the electron beam $EB_S$ is higher than that of the electron beam $EB_M$, the reflected electrons $R_{1S}$ of the electron beam $EB_S$ have a higher energy than the reflected electrons $R_{1M}$ of the electron beam $EB_M$. Thus, it is possible for the detector to detect only the reflected electrons $R_{1S}$ from the electron beam $EB_S$ by utilizing the above-mentioned energy difference of the reflected electrons. In addition, since the acceleration voltage of the electron beam $EB_S$ is high, the electron beam $EB_S$ is easy to focus to a narrow beam and has a low resist sensitivity, these features being desired for position detection. The current density of the sub-electron beam $EB_S$ should be weak enough that the resist on the wafer surface is not substantially exposed by the electron beam $EB_S$. Thus, a field emission type electron gun or the like may be used as the electron source of the sub-electron beam $EB_S$. On the other hand, the main electron beam $EB_M$ is used for formation of the circuit patterns on the wafer surface, and it is desired that the main electron beam $EB_M$ have a rather wide beam diameter and a high resist sensitivity. The beam shape of the main electron beam $EB_M$ may be circular or may be rectangular, and its beam diameter may be adjustable.

In the electron beam exposure method of Figure 4, by projecting the sub-electron beam $EB_S$ simultaneously or previously on the positions to be projected by the main electron beam $EB_M$, the center of the area projected by the main electron beam $EB_M$ on the wafer surface, that is, the field center, can be detected to a high precision by means of the reflected electrons of the sub-electron beam $EB_S$, so that the above-mentioned field center can be corrected to coincide with the desired wafer surface position. The position detection by means of the reflected electrons may be carried out by using positioning marks formed beforehand on the wafer surface or using the wiring pattern formed on the wafer surface.

As described above, according to the embodiment of the present invention of Figure 4, since separate electron beams are used for exposure and for position detection, even if the diameter of the electron beam for the exposure is large, the wafer position can be detected to a high precision. Therefore, the desired patterns can be formed at correct positions on the wafer surface.

**Claims**

1. An electron beam exposure method comprising the steps of:—

generating a high acceleration voltage electron beam ($EB_H$) from a high acceleration voltage electron beam source (10) and a low acceleration voltage electron beam ($EB_L$) from a low acceleration voltage electron beam source (11), both the electron beams ($EB_H$, $EB_L$) being controlled independently in an electron beam exposure apparatus;

forming fine patterns on a resist layer formed on a substrate (12) by scanning the high acceleration voltage electron beam ($EB_H$) from the source (10) in one predetermined area of a surface of the resist layer; and,

forming coarse patterns on the resist layer by scanning the low acceleration voltage electron beam ($EB_L$) from the source (11) in another, different, predetermined area of a surface of the resist layer.

2. An electron beam exposure method comprising the steps of:—

generating a high acceleration voltage electron beam ($EB_S$) from a high acceleration voltage electron beam source (21) and a low acceleration voltage electron beam ($EB_M$) from a low acceleration voltage electron beam source (20), both electron beams ($EB_S$, $EB_M$) being controlled independently in an electron beam exposure apparatus, the high acceleration voltage electron beam ($EB_S$) being focussed to a narrow beam diameter and having an intensity weak enough not to cause substantial exposure of the resist layer;

scanning the high acceleration voltage electron beam (EBₛ) from the source (21) over the surface of a resist layer formed on a substrate;

obtaining information on the position of the substrate by detecting electrons reflected from the high acceleration voltage electron beam (EBₛ); and,

forming predetermined patterns on the resist layer by projecting the low acceleration voltage electron beam (EB$_M$) from the source (20) onto the resist layer, the projection position of the low acceleration voltage electron beam (EB$_M$) being determined from the obtained information on the position of the substrate.

3. An electron beam exposure apparatus comprising a high acceleration voltage electron beam source (10) and a low acceleration voltage electron beam source (11), the high acceleration voltage electron beam (EB$_H$) from the source (10) being capable of being projected onto the surface of a resist layer formed on a substrate (12) and of being used to expose the resist layer to form fine patterns on it, the low acceleration voltage electron beam (EB$_L$) from the source (11) being capable of being projected onto the surface of the resist layer and capable of being used to expose the resist layer to form coarse patterns on it, and both of the electron beams (EB$_H$, EB$_L$) being capable of being controlled independently in the electron beam exposure apparatus to expose different areas of the resist layer simultaneously.

4. An electron beam exposure apparatus comprising:

a high acceleration voltage electron beam source (21) capable of emitting a high acceleration voltage electron beam (EBₛ) having a narrow beam diameter for detecting the position of resist layer formed on a substrate (22), the high acceleration voltage electron beam (EBₛ) having an intensity weak enough not to cause substantial exposure of the resist layer;

a low acceleration voltage electron beam source (20) capable of emitting a low acceleration voltage electron beam (EB$_M$) having an intensity sufficient to cause exposure of the resist layer, and being capable of being projected onto a predetermined area of the surface of the resist layer, means to control scanning of both the electron beams (EBₛ, EB$_M$) independently of one another; and,

means (24) for obtaining information on the position of the substrate by detecting electrons reflected from the high acceleration voltage electron beam, the obtained information of the substrate position being used for determining the projection position of the low acceleration voltage electron beam (EB$_M$).

**Patentansprüche**

1. Elektronenstrahl-Bestrahlungsverfahren mit den folgenden Schritten:—

Erzeugung eines Elektronenstrahls hoher Beschleunigungsspannung (EB$_H$) von einer Elektronenstrahlquelle (10) hoher Beschleunigungsspannung, und eines Elektronenstrahls niedriger Beschleunigungsspannung (EB$_L$) von einer Elektronenstrahlquelle (11) niedriger Beschleunigungsspannung, wobei beide Elektronenstrahlen (EB$_H$, EB$_L$) in einer Elektronenstrahl-Bestrahlungsvorrichtung unabhängig gesteuert werden;

Bildung feiner Muster einer Resistschicht, die auf einem Substrat (12) gebildet ist, durch Scannen des Elektronenstrahls hoher Beschleunigungsspannung (EB$_H$) von der Quelle (10) in einem vorbestimmten Bereich einer Oberfläche der Resistschicht; und,

Bildung grober Muster auf der Resistschicht durch Scannen mit dem Elektronenstrahl niedriger Beschleunigungsspannung (EB$_L$) von der Quelle (11) in einem anderen, unterschiedlichen, vorbestimmten Bereich der Oberfläche der Resistschicht.

2. Elektronenstrahl-Bestrahlungsverfahren mit den folgenden Schritten:—

Erzeugung eines Elektronenstrahls (EBₛ) hoher Beschleunigungsspannung von einer Elektronenstrahlquelle (21) hoher Beschleunigungsspannung, und eines Elektronenstrahls (EB$_M$) niedriger Beschleunigungsspannung von einer Elektronenstrahlquelle (20) niedriger Beschleunigungsspannung, wobei beide Elektronenstrahlen (EBₛ, EB$_M$) in einer Elektronenstrahl-Bestrahlungsvorrichtung unabhängig gesteuert werden und der Elektronenstrahl (EBₛ) hoher Beschleunigungsspannung auf einen engen Strahlendurchmesser fokusiert wird und eine Intensität hat, die weich genug ist, um eine wesentliche Bestrahlung der Resistschicht zu bewirken;

Scannen über die Oberfläche einer Resistschicht, die auf einem Substrat gebildet ist, mit dem Elektronenstrahl (EBₛ) hoher Beschleunigungsspannung von der Quelle (21);

Erhalten von Information über die Position des Substrates durch Detektieren von reflektierten Elektronen, von dem Elektronenstrahl (EBₛ) hoher Beschleunigungsspannung, und,

Bildung vorbestimmter Muster auf der Resistschicht durch Projizieren des Elektronenstrahls (EB$_M$) niedriger Beschleunigungsspannung von der Quelle (20) auf die Resistschicht, wobei die Projektionsposition des Elektronenstrahls niedriger Beschleunigungsspannung (EB$_M$) bestimmt wird durch die erhaltene Information über die Position des Substrates.

3. Elektronenstrahl-Bestrahlungsvorrichtung mit einer Elektronenstrahlquelle hoher Beschleunigungsspannung (10) und einer Elektronenstrahlquelle niedriger Beschleunigungsspannung (11), bei der der Elektronenstrahl (EB$_H$) hoher Beschleunigungsspannung von der Quelle (10) auf die Oberfläche einer Resistschicht projiziert werden kann, die auf einem Substrat (12) gebildet ist, und zur Bestrahlung der Resistschicht verwendet werden kann, um feine Muster auf ihr zu bilden, und der Elektronenstrahl niedriger Beschleunigungsspannung (EB$_L$) von der Quelle (11) auf die Oberfläche der Resistschicht projiziert und zur Bestrahlung der Resistschicht verwendet werden kann, um grobe Muster auf ihr zu bilden, und beide Elektronenstrahlen (EB$_H$, EB$_L$) unabhängig in der Elektronenstrahlvorrichtung gesteuert werden können, um verschiedene Bereiche der Resistschicht gleichzeitig zu bestrahlen.

4. Elektronenstrahlvorrichtung mit:

einer Elektronenstrahlquelle (21) hoher Beschleunigungsspannung, die einen Elektronenstrahl (EB$_S$) hoher Beschleunigungsspannung emittieren kann, welcher einen engen Durchmesser hat, um die Position der Resistschicht, die auf einem Substrat (22) gebildet ist, zu detektieren, wobei der Elektronenstrahl (EB$_S$) hoher Beschleunigungsspannung eine Intensität hat, die weich genug ist, um eine wesentliche Bestrahlung der Resistschicht zu verursachen;

einer Elektronenstrahlquelle (20) niedriger Beschleunigungsspannung, die einen Elektronenstrahl (EB$_M$) niedriger Beschleunigungsspannung emittieren kann, welcher eine Intensität hat, die ausreicht, um die Bestrahlung der Resistschicht zu bewirken, und der auf einen vorbestimmten Bereich der Oberfläche der Resistschicht projiziert werden kann, und Einrichtungen zur Steuerung des Scannens mit beiden Elektronenstrahlen (EB$_S$, EB$_M$) unabhängig voneinander; und,

Einrichtungen (24) zur Ermittlung von Information über die Position auf dem Substrat durch Detektieren von Elektronen die von dem Elektronenstrahl hoher Beschleunigungsspannung reflektiert werden, wobei die ermittelte Information über die Substratposition zur Bestimmung der Projektionsposition des Elektronenstrahls niedriger Beschleunigungsspannung (EB$_M$) verwendet wird.

## Revendications

1. Procédé d'exposition à un faisceau d'électrons, consistant: à produire un faisceau d'électrons à haute tension d'accélération (EB$_H$) à partir d'une source (10) de faisceau d'électrons à haute tension d'accélération et un faisceau d'électrons à haute tension d'accélération et un faisceau d'électrons à basse tension d'accélération (EB$_L$) à partir d'une source (11) de faisceau d'électrons à basse tension d'accélération, les deux faisceaux d'électrons (EB$_H$, EB$_L$) étant commandés indépendamment dans un appareil d'exposition à un faisceau d'électrons, à former des fines configurations sur une couche sensible formée sur un substrat (12) en balayant avec le faisceau d'électrons à haute tension d'accélération (EB$_H$) provenant de la source (10) une région prédéterminée d'une surface de la couche sensible; et à former des configurations grossières sur la couche sensible en balayant avec le faisceau d'électrons à basse tension d'accélération (EB$_L$) provenant de la source (11) une autre région différente prédéterminée d'une surface de la couche sensible.

2. Procédé d'exposition à un faisceau d'électrons, consistant: à produire un faisceau d'électrons à haute tension d'accélération (EB$_S$) à partir d'une source (21) de faisceau d'électrons à haute tension d'accélération et un faisceau d'électrons à basse tension d'accélération (EB$_M$) à partir d'une source (20) de faisceau d'électrons à basse tension d'accélération, les deux faisceaux d'électrons (EB$_S$, EB$_M$) étant commandés indépendamment dans un appareil d'exposition à un faisceau d'électrons, le faisceau d'électrons à haute tension d'accélération (EB$_S$) étant focalisé à un diamètre étroit du faisceau et ayant une intensité suffisamment faible pour ne produire aucune exposition substantielle de la couche sensible; à balayer avec le faisceau d'électrons à haute tension d'accélération (EB$_S$) provenant de la source (21), la surface d'une couche sensible formée sur un substrat; à obtenir des informations sur la position du substrat en détectant des électrons réfléchis depuis le faisceau d'électrons à haute tension d'accélération (EB$_S$); et à former des configurations prédéterminées sur la couche sensible en projetant le faisceau d'électrons à basse tension d'accélération (EB$_M$) provenant de la source (20) sur la couche sensible, la position de projection du faisceau d'électrons à basse tension d'accélération (EB$_M$) étant déterminée à partir des informations obtenues sur la position du substrat.

3. Appareil d'exposition à un faisceau d'électrons, comportant une source (10) de faisceau d'électrons à haute tension d'accélération et unesource (11) de faisceau d'électrons à basse tension d'accélération, le faisceau d'électrons à haute tension d'accélération (EB$_H$) provenant de la source (10) pouvant être projetée sur la surface d'une couche sensible formé sur un substrat (12) et étant utilisé pour exposer la couche sensible de manière à former des fines configurations sur elle; le faisceau d'électrons à basse tension d'accélération (EB$_L$) provenant de la source (11) pouvant être projeté sur la surface de la couche sensible et pouvant être utilisé pour exposer la couche sensible pour former des configurations grossières sur elle, et les deux faisceaux d'électrons (EB$_H$, EB$_L$) pouvant être commandés indépendamment dans l'appareil d'exposition à un faisceau d'électrons pour exposer simultanément des régions différentes de la couche sensible.

4. Appareil d'exposition à un faisceau d'électrons, comportant: une source (21) de faisceau d'électrons à haute tension d'accélération capable d'émettre un faisceau d'électrons à haute tension d'accélération (EB$_S$) ayant un diamètre de faisceau étroit pour détecter la position d'une couche sensible formée sur un substrat (22), le faisceau d'électrons à haute tension d'accélération (EB$_S$) ayant une intensité suffisamment faible pour ne pas entraîner une exposition substantielle de la couche sensible; une source (20) de faisceau d'électrons à basse tension d'accélération capable d'émettre un faisceau d'électrons à basse tension d'accélération (EB$_M$) ayant une intensité suffisante pour entraîner une exposition de la couche sensible et pouvant être projeté sur une région prédéterminée sur la surface de la couche sensible un dispositif pour commander indépendamment l'un de l'autre le balayage des deux faisceaux d'électrons (EB$_S$) EB$_M$; et un

6

dispositif (24) destiné à obtenir des informations sur la position du substrat en détectant des électrons réfléchis depuis le faisceau d'électrons à haute tension d'accélération, les informations obtenues sur la position du substrat étant utilisées pour déterminer la position de projection du faisceau d'électrons à basse tension d'accélération (EB$_M$).

## Fig. 1

## Fig. 2

(a)

(b) $R_{1M}$

(c) $R_{1S}$

*Fig. 3*

*Fig. 4*